# EUROPEAN PATENT APPLICATION

(11) **EP 4 682 555 A1**
(43) Date of publication of application: **21.01.2026**
(21) Application number: 24425035.3
(22) Date of filing: 15.07.2024
(51) Int. Cl.: G01R 31/28

(54) **AUTOMATED TEST EQUIPMENT (ATE) FOR PERFORMING AUTOMATED DYNAMIC TESTS AND/OR DIRECT CURRENT (DC) TESTS ON ELECTRONIC DEVICES**

(71) Applicant: Microtest S.p.A., 56010 Vicopisano (PI) (IT)
(72) Inventor: AMELIO, Giuseppe, 55100 San Pietro (LU) (IT)
(74) Representative: Botti & Ferrari S.p.A.

(57) **Abstract**

Automated test equipment (100) comprising:
a housing (130) for a device under test (200);
a first hardware portion (110) arranged to perform dynamic tests, in particular alternating current dynamic tests, on the device under test (200);
a second hardware portion (120) arranged to perform direct current tests on the device under test (200);
a first relay barrier (133) interposed between the hardware of the first portion (110) and the device under test (200);
a second relay barrier (134) interposed between the hardware of the second portion (120) and the device under test (200);
wherein the first relay barrier (133) and the second relay barrier (134) can be alternatively switched to allow performing dynamic tests via the first hardware portion (110) or direct current tests via the second hardware portion (120).

## Description

### Field of application

The present invention is generally directed to the field of automated test equipment (ATE) and, more particularly, to an equipment that allows performing both direct current (DC) tests and dynamic alternating current (AC) tests on a device under test (DUT).

Said equipment is generally adapted to perform tests on electronic devices of different types, including silicon carbide (SiC) and gallium nitride (GaN) electronic devices.

### Prior art

Automated test equipment (ATE), also known as testers, is commonly used to test both semiconductor devices and assembled printed circuits to determine whether said devices or boards are defective.

The use of ATEs is essential to ensure that the electronic devices properly operate in actual conditions of use. These tests allow performance and safety issues to be identified and corrected before products are released to the market.

In general, an ATE is arranged to verify the operation of a device under test (DUT), which can be a semiconductor device or a printed circuit. The DUT is inserted into a specific housing recess known in the sector as socket.

The ATE applies signals and test sequences to the DUT housed in the socket. The ATE then receives the output signals sent by the DUT in response to the applied signals and typically compares said output signals with expected signals stored in the memory.

The ATE can furthermore measure various parameters associated with the DUT, such as the power dissipated under different conditions of use or the frequency of the output signals, comparing them with expected values.

If any one of the received signals or measured values do not correspond to what is expected, the ATE typically diagnoses a defect in the DUT.

In the ATE technology, DC (direct current) tests and dynamic (alternating current) tests serve different purposes and are used to evaluate different aspects of electronic components and systems.

The ATEs on the market generally require the transfer of the DUT from one socket to another in order to perform the different types of tests defined above. This need for transferring represents an obvious disadvantage since it causes an increase in the DUT testing times.

The technical problem underlying the present invention is therefore to create an ATE that solves at least in part the problems of the prior art, and which in particular allows performing DC tests and dynamic tests on the same DUT without the need of transferring from one socket to another.

### Summary of the invention

The solution idea underlying the present invention is to build two micro-relay barriers in order to allow the DUT to be connected alternatively to a circuitry for performing dynamic tests or to a circuitry for performing DC tests.

In particular, the technical problem identified above is solved by an ATE comprising:
a housing for a DUT;
a first hardware portion arranged to perform dynamic tests, in particular alternating current dynamic tests, on the DUT;
a second hardware portion arranged to perform direct current tests on the DUT;
a first relay barrier interposed between the hardware of the first portion and the DUT;
a second relay barrier interposed between the hardware of the second portion and the DUT;
wherein the first relay barrier and the second relay barrier can be alternatively switched to allow performing dynamic tests via the first hardware portion or direct current tests via the second hardware portion.

Preferably, the device is configured such that when the first relay barrier is closed, the second relay barrier is necessarily open and, vice versa, when the second relay barrier is open, the first relay barrier is necessarily closed.

The device cannot conversely preclude a configuration in which both relay barriers are open.

Preferably, the housing comprises a socket for a semiconductor device or a printed circuit.

Preferably, the ATE allows performing both DC and dynamic tests also on silicon carbide (SiC) and gallium nitride (GaN) devices.

Preferably, the ATE housing can be coupled to the second hardware portion via a DC connector, said DC connector being configured to connect to the second portion with a preferably flexible transmission cable.

Preferably, the housing can be coupled to the first hardware portion via an AC connector, said AC connector being configured to allow the hard docking of the housing with the first hardware portion.

Preferably, said DC connector and said AC connector are positioned opposite each other on the housing.

The first hardware portion can comprise a first measurement and control module and/or a first digital interface module.

The second hardware portion can comprise a second measurement and control module and/or a second digital interface module.

The ATE can also comprise a user interface module, which can be made of a computer or a generic workstation that is part of the ATE.

Said first relay barrier and/or said second relay barrier, preferably both, can comprise at least one first terminal and at least one second terminal, at least one actuation unit comprising an electrovalve and an actuator which is integral with a contact plate which is capable of moving from a first position, in which it is in contact with both said at least one first terminal and said at least one second terminal by putting them in electrical contact, to a second stop position, in which it is distant from said at least one first terminal and at least one second terminal, wherein said electrovalve is arranged to control said actuator by moving said contact plate between said first stop position and said second stop position.

Preferably, said at least one first terminal and at least one second terminal comprise electrical contacts which are retractable within a respective housing in opposition to the abutment of an elastic element.

Preferably, said first relay barrier and/or said second relay barrier comprise a plurality of first terminals, a plurality of second terminals and a plurality of contact plates configured to short-circuit said first and second terminals two by two, wherein a single relay barrier instead comprises a single actuation unit arranged to synchronously move said plurality of contact plates.

Preferably, the aforementioned actuator comprises a piston which is movable in a cylinder and is connected by a stem to a front plate carrying said contact plate.

Preferably, said actuator comprises a spring or similar elastic means acting on said movable piston in opposition to the movement of said movable piston controlled by said electrovalve.

Said first terminal, said second terminal and said contact plate define a main circuit. In one embodiment, the first and/or second relay barriers further comprise at least one diagnostic circuit adapted to detect the correct opening and closing conditions of the main circuit.

The diagnostic circuit can be only one for the entire relay barrier or a plurality of diagnostic circuits adapted to verify the closing/opening conditions of each single pair of contacts can be provided.

The diagnostic circuit can comprise a first pair of interface contacts which are accessible from the outside of a casing, the diagnostic circuit being configured to short-circuit the first pair of interface contacts only when the main circuit is in open configuration with the front plate in the corresponding first stop position.

The contacts of the first pair of interface contacts can be connected two by two with the contacts of a second pair of interface contacts, said second pair of interface contacts internally facing onto the chamber in which the front plate runs, said front plate comprising at least one conductive portion which comes into contact with the second pair of interface contacts, short-circuiting it, when said front plate reaches the first stop position.

The diagnostic circuit can also comprise a third pair of interface contacts which are accessible from the outside of a casing, the diagnostic circuit being configured to short-circuit the third pair of interface contacts only when the main circuit is in closed configuration with the front plate in the corresponding second stop position.

The characteristics and advantages of the device will be apparent from the description of an embodiment given by way of illustrative and nonlimiting example with reference to the attached drawings.

### Brief description of the drawings

Figure 1 schematically shows an automated test equipment according to the present invention.
Figure 2 shows a schematic side sectional view of a first embodiment of a relay of the type used in the relay barriers of the automated test equipment of figure 1, in a first state.
Figure 3 shows a schematic side sectional view of the device shown in figure 2, in a second state.
Figure 4 shows an exploded view of the relay of figure 2.
Figure 5 shows an axonometric view of a section of the relay of figure 2.
Figure 6 shows a further axonometric view of a section of the relay of figure 2, in a first state.
Figure 7 shows a front view of the relay of figure 6, in a second state.
Figure 8 shows a front view of a section of a part of the relay of figure 2, in a first state.
Figure 9 shows a further front view of a section of a further part of the relay of figure 2, in a first state.
Figure 10 shows a front view of a section of the relay of figure 2, in an open state.
Figure 11 shows a front view of the device shown in figure 10, in a first uncertain state.
Figure 12 shows a front view of the device shown in figure 10, in a second uncertain state.
Figure 13 shows a front view of the device shown in Figure 10, in a closed state.

### Detailed Description

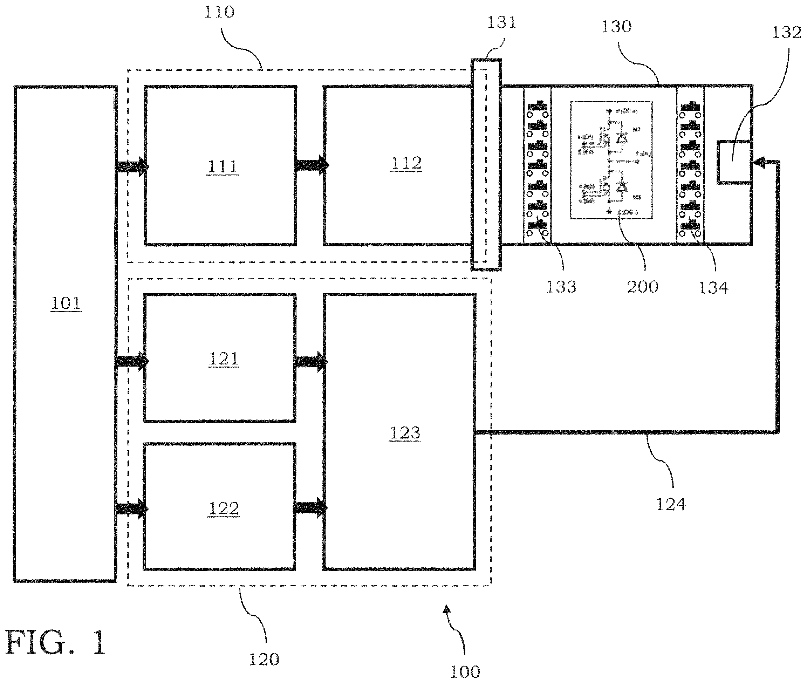

With reference to figure 1, 100 globally and schematically identifies an automated test equipment (ATE) for performing dynamic tests or DC tests on a device under test (DUT), identified with 200, said DUT 200 being a semiconductor device or a printed circuit.

The ATE 100 comprises a cabinet 101 in which the hardware required to perform tests on the DUTs 200 is contained.

The aforementioned hardware comprises a first portion 110 dedicated to the dynamic tests, in particular alternating current (AC) dynamic tests.

The first portion 110 comprises a first measurement and control module 111, which is responsible for acquiring measurements and monitoring parameters in the context of the dynamic tests performed by means of the ATE 100.

The first portion 110 also comprises a first analog-digital interface module 112, which allows the actual transmission of the signal from and to the DUT 200 in the context of the dynamic tests.

The hardware also comprises a second portion 120 dedicated to the DC tests.

The second portion 120 comprises a second measurement and control module 121, which is responsible for acquiring measurements and monitoring parameters in the context of DC tests performed by means of the ATE 100. The second measurement and control module 112 is configured for both high-voltage and low-voltage tests.

The second portion 120 further comprises a user interface module 122. Said user interface module 122 can be made of a computer or a generic workstation that is part of the ATE 100. The module provides a graphical interface (GUI) or a command line interface (CLI) through which users can interact with the ATE 100, can control the performance of the tests, can monitor the results and can analyze data.

The second portion 120 also comprises a second analog-digital interface module 123, which allows the actual transmission of the signal from and to the DUT 200 in the context of the DC tests.

The ATE 100 also comprises a housing 130 for a DUT 200. Said housing 130 can be made on a tray, arranged to be inserted into the cabinet 101, or in any other manner known in the art. It defines a socket into which the DUT is inserted.

It is noted that, although a single housing 130 for a DUT 200 is represented for sake of simplicity in figure 1, the housings 130 can be a plurality in order to allow the simultaneous performance of tests on a corresponding plurality of DUTs 200.

The ATE 100 comprises an AC connector 131, in particular a rigid connector or fixture for the direct and rigid connection (so-called hard docking) of the first hardware portion 110 dedicated to the dynamic tests to the housing 130.

In particular, the AC connector 131 interfaces with the previously defined first digital interface module 112.

The AC connector 131 is arranged to bidirectionally transmit alternating current signals.

The ATE 100 also comprises a DC connector 132 arranged to electrically connect a transmission cable 124 of direct current signals.

The transmission cable 124 connects the second hardware portion 120, in particular the second digital interface module 123, with the housing 130.

The transmission cable 124 is preferably of the flexible type.

The AC connector 131 and the DC connector 132 are preferably arranged opposite to the housing 130.

The AC connector 131 is connected to the DUT 200 in the socket via a first relay barrier 133 which alternatively allows an interruption or allows the electrical transmission between AC connector 131 and DUT 200.

The DC connector 132 is connected to the DUT 200 in the socket via a second relay barrier 134 which alternatively allows an interruption or allows the electrical transmission between AC connector 131 and DUT 200.

The first and second relay barriers 133, 134 are designed and made in particular to alternatively perform static or dynamic tests in circuit diagnostic devices.

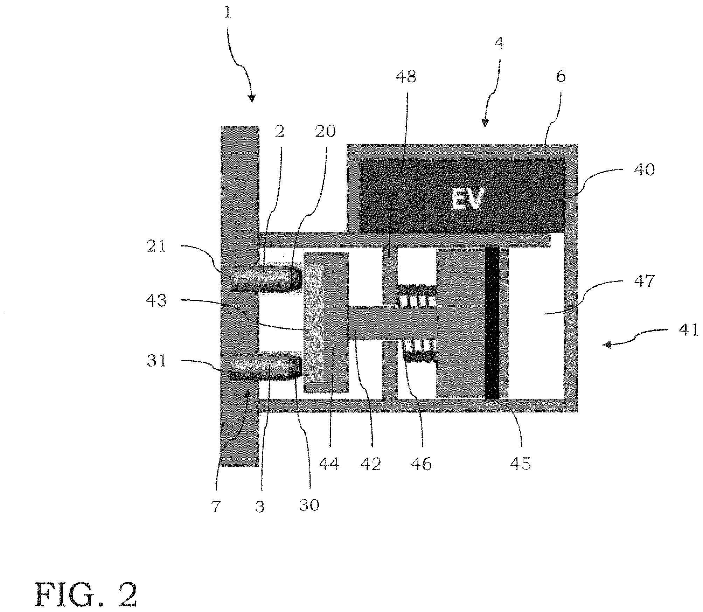

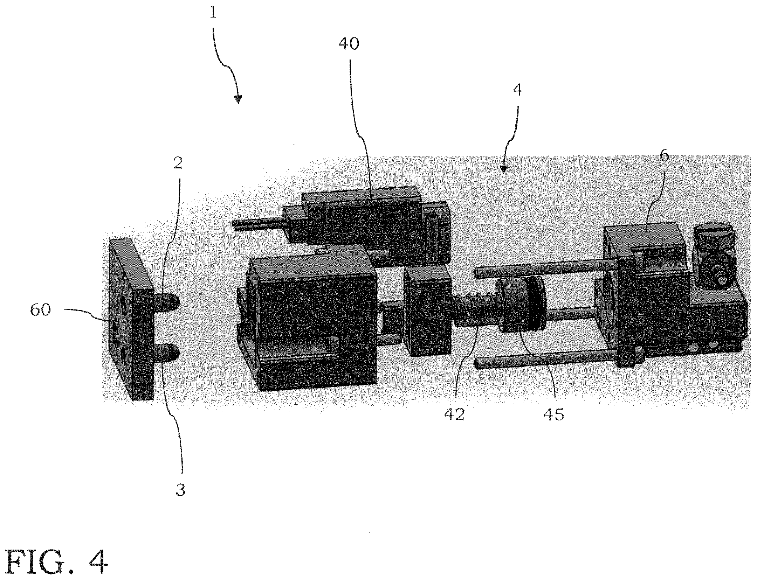

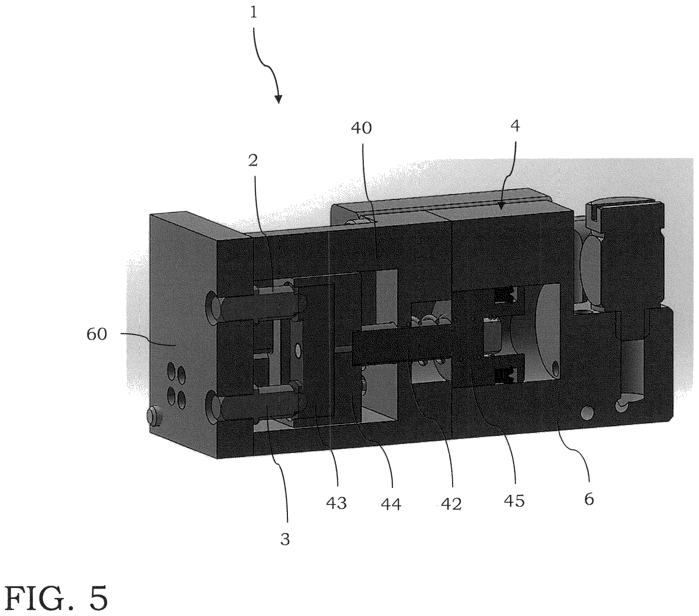

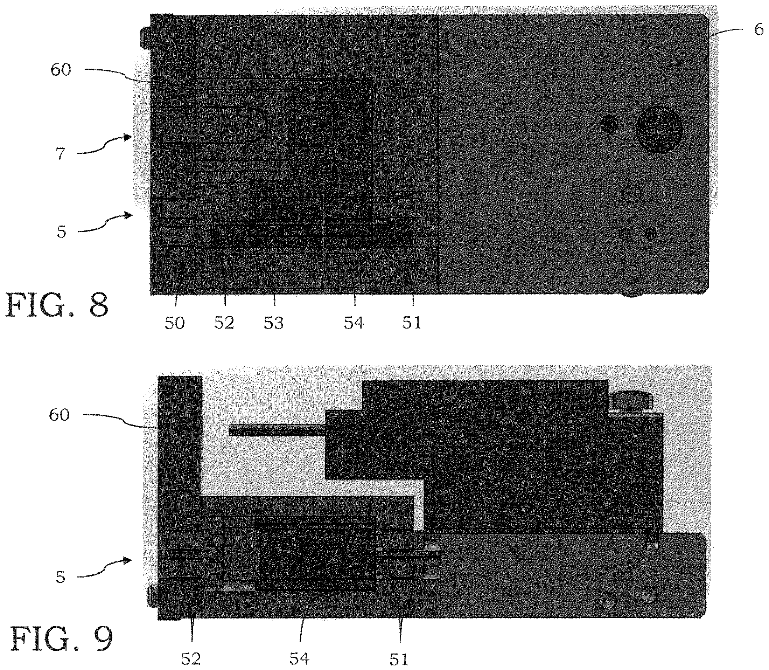

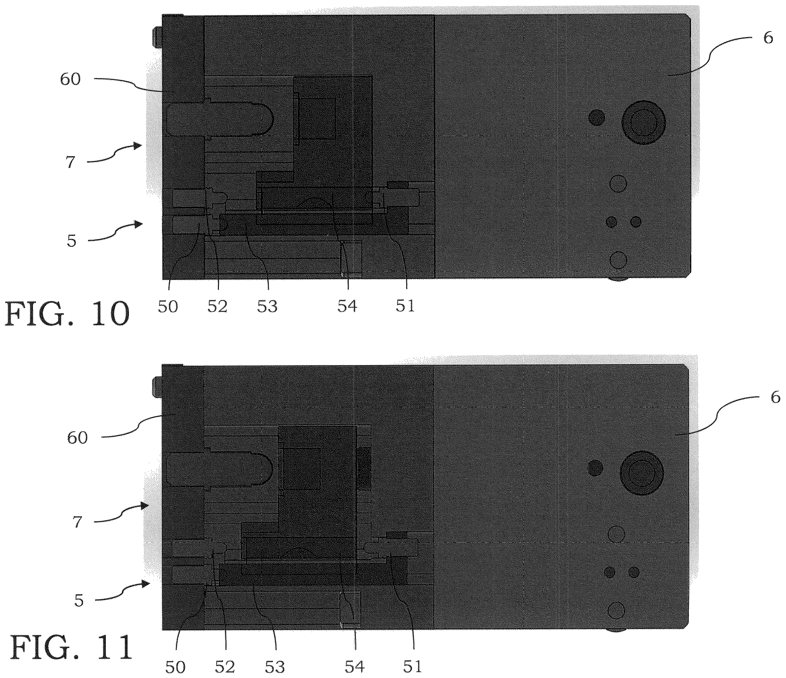

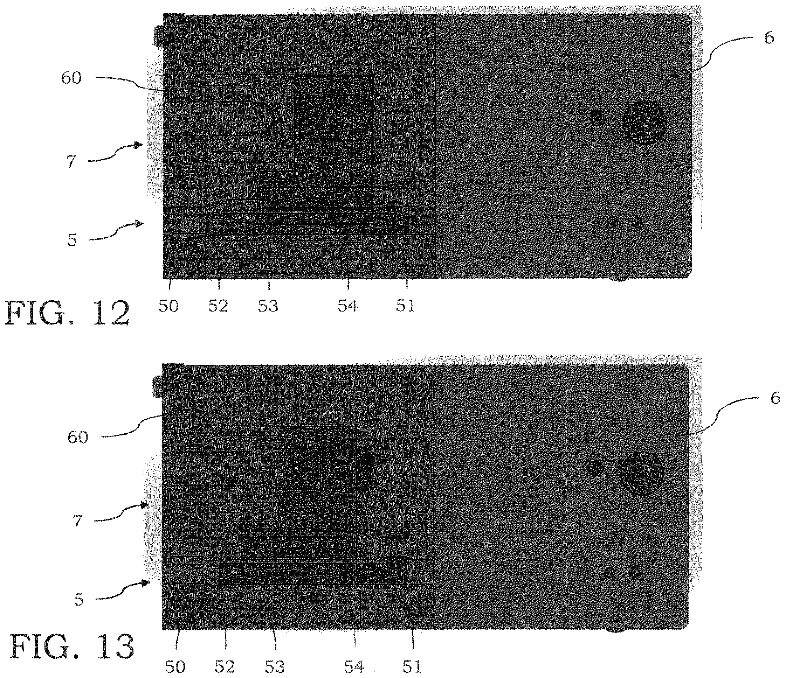

In particular, with reference to figures 2-13, a single relay made according to the general principle used for the first and second relay barriers 133, 134 is described below.

Naturally, the relay barriers 133, 134 used in the context of the ATE 100 according to the present invention, even if they maintain the components described below, will have a plurality of contacts, or, employing the terms used below, a plurality of first terminals 2 and a plurality of second terminals 3.

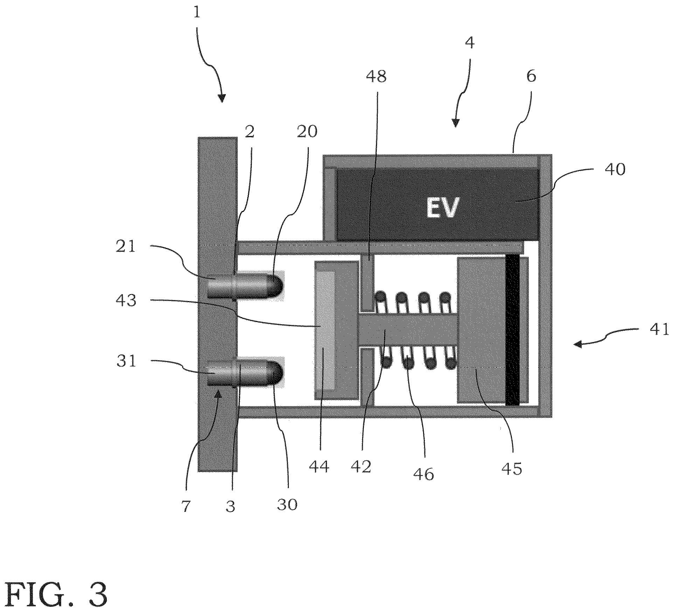

Referring to figures 2 and 3, the relay 1 essentially comprises a casing 6, a first terminal 2, a second terminal 3, an actuation unit 4.

In particular, said relay 1 is a SPST (single pole, single throw) relay that can be used for high intensity voltages and currents and is capable of performing a high number of switching operations.

Said casing 6 is made of highly insulating, PEEK - Polyether Ether Ketone - material.

Said first 2 and said second 3 terminals are in particular similar to devices which are commercially known as pogo pins.

Typically a pogo pin is a spring pin, comprising a plunger, a sleeve-shaped housing and a spring.

When force is applied to the pin, the spring is compressed and the plunger moves inside the housing.

The sleeve-shape of the housing retains the plunger, thus preventing the spring from pushing it out when the pin is not locked in place.

Said actuation unit 4 comprises an electrovalve 40 and a pneumatic actuator 41.

Said electrovalve 40 is integrated at a minimum distance from said pneumatic actuator 41.

Said pneumatic actuator 41 moves a contact plate 43 capable of moving from a first stop position, in which it is in contact with both said at least one first terminal 2 and said at least one second terminal 3 by putting them in electrical contact, to a second stop position, in which the contact plate 43 is distant from the first terminal 2 and from the second terminal 3.

Said first terminal 2, said second terminal 3 and said contact plate 43 define a main circuit 7.

In particular, said actuator 41 comprises a piston 45 which is movable in a cylinder 47 and is connected by a stem 42 to a front plate 44 which carries said contact plate 43.

Said cylinder 47 is separated into two portions by a bulkhead 48 which separates the stroke of the movable piston 45 from the stoke of the front plate 44.

Furthermore, said actuator 41 comprises a spring 46 acting on said movable piston 45 in opposition to the movement of said movable piston 45 controlled by said electrovalve 40, defining a single-acting actuator configuration.

Said electrovalve 40 is arranged to control said actuator 41 by moving said contact plate 43 between said first stop position and said second stop position.

Said first terminal 2 and said second terminal 3 comprise electrical contacts 20, 30 which are retractable within a respective housing 21, 31 in opposition to the abutment of an elastic element.

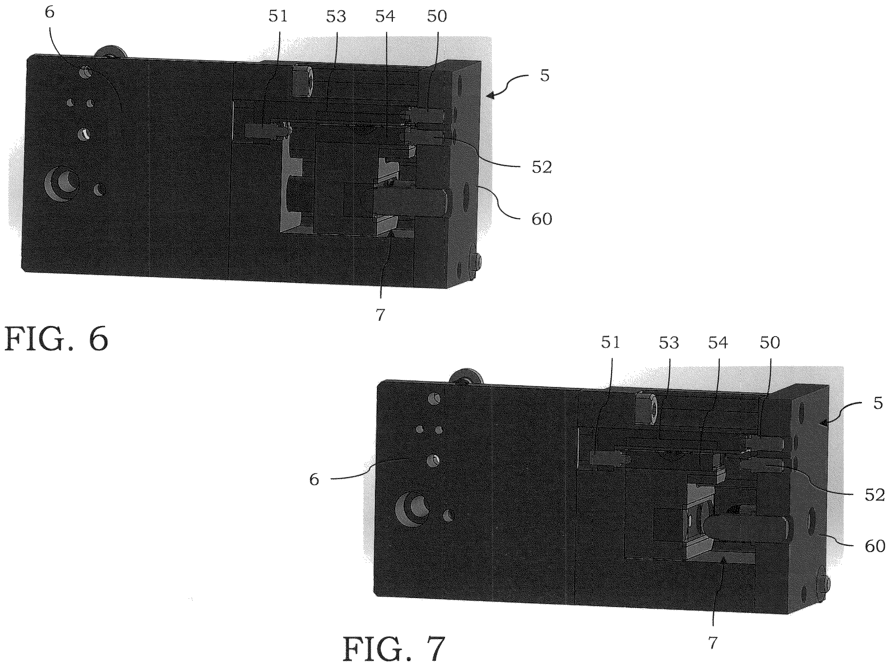

The relay 1 can also comprise a diagnostic circuit 5, which is visible in particular in the embodiment illustrated in figures 6-13.

Said diagnostic circuit 5 is able to verify the state of the relay 1, so as to prevent a harmful electrical stress.

In particular, said diagnostic circuit 5 comprises a first pair of interface contacts 50, a second pair of interface contacts 51, and a third pair of interface contacts 52.

Said first 50 and said second 51 pairs of interface contacts are able to detect the open circuit condition of the main circuit 7, while said third pair of interface contacts 52 is able to detect the closed circuit condition.

Said first 50 and said third 52 pairs of interface contacts face externally from said casing 6, in particular from a bottom 60, onto which the first 2 and second 3 terminals of said main circuit 7 face.

Said second pair 51 is arranged within said casing 6, in particular it faces onto the cylinder portion 47 downstream of said bulkhead 48, in opposition to the first 50 and third 52 pairs of interface contacts.

Said pairs of contacts 50-52, similarly to the contacts of said main circuit 7, are contacts which are retractable within a respective fixed case and are held in the extracted position by an internal return spring.

Said second 51 and said third 52 pairs of interface contacts interfere both with the stroke of the front plate 44, in particular of a side portion 49 of said front plate 44. In the preferred embodiment, shown herein, said side portion 49 has an increased thickness with respect to the rest of the front plate 44.

Said first pair of contacts 50 is instead arranged in a position distant from the cylinder 47 in which the front plate 44 slides.

The contacts of said first 50 and said second 51 pairs of contacts are connected two by two by a pair of connectors 53 which passes through the casing 6.

At least one conductive portion 54 configured to short-circuit each time the two connectors of the second pair 51 or the two connectors of the third pair 52 is provided in the side portion 49 of the front plate 44.

In a particularly advantageous preferred embodiment, said at least one conductive portion 54 is made up of a single conductive body that passes through the entire thickness of the side portion 49.

The operation of the relay 1 described above takes place as follows.

When the relay 1 is activated, said actuation unit 4 moves said contact plate 43, activating or deactivating said main circuit 7.

In particular, said electrovalve 40 controls said actuator 41 by moving said contact plate 43 between said second stop position and said first stop position; the spring 46 then allows the front plate 44 to return to the second stop position when the operation of the actuator 41 stops.

In said first stop position, said contact plate 43 is in contact with said first 2 and said second 3 terminals, activating said main circuit 7.

In said second stop position, said contact plate 43 is distant from said first 2 and said second 3 terminals, since said spring 46 extends, therefore retracting said contact plate 43, thus deactivating said main circuit 7.

Said diagnostic circuit 5 is able to detect the correct opening and closing conditions of the main circuit 7.

Said main circuit 7 can be in an open position, in a first uncertain position, in a second uncertain position and in a closed position. The first uncertain position is a position in which the main circuit 7 is open but the front plate is stationary in an intermediate position, without having reached the second stop position. Similarly, the second uncertain position is a position in which the main circuit 7 is closed but the front plate 44 has not reached the first stop position: in other words, the retractable electrical contacts 20, 30 come into contact with the contact plate 43, but the front plate 44 does not push them all the way into their housing 21, 31.

To perform the aforementioned diagnostics, said conductive portion 54 short-circuits said second pair of interface contacts 51 only when the main circuit is in open configuration with the front plate 44 in a corresponding first stop position. Therefore, by reading the output signal from the pair of first interface contacts 50, in electrical connection with the second contacts 51, a positive is obtained only in the case of correct opening of the main circuit 7.

Conversely, the opposite end of the same conductive portion 54 comes into contact with the third pair of interface contacts 52, short-circuiting it, when said front plate 44 reaches the first stop position. Therefore, by reading the output signal from the pair of third interface contacts 52, a positive is obtained only in the case of correct closure of the main circuit 7.

Furthermore, during the movement of the front plate 41 from the first stop position towards said second stop position, the contact plate 43 reaches the retractable electrical contacts 20, 30 of the first 2 and second 3 terminals, before said conductive portion 54 reaches the third pair of interface contacts 52. The third pair of interface contacts 52 is therefore not automatically short-circuited upon closing of the main circuit 7, allowing situations related to the second aforementioned uncertain position to be identified.

Of course, the relays 1 of the relay barriers 133, 134 are miniaturized in order to be integrated at the housing 130 of the DUT 200.

As previously mentioned, the relay barriers 133, 134 have a plurality of first 2 and second 3 terminals. Preferably, a single actuation unit 4, provided with a plurality of contact plates 43 is used, so that the relay barriers 133, 134 have two configurations, the first with all contacts open, the second with all contacts closed.

The relay barriers 133, 134 can or cannot comprise the diagnostic circuit 5; in particular, a single diagnostic circuit 5 can be considered for the entire barrier or a plurality of diagnostic circuits 5 can be present in order to identify the correct closing/opening status of each single pair of terminals 2, 3.

In use, the ATE 100 can perform dynamic tests by closing the first relay barrier 133 and opening the second relay barrier 134; vice versa the ATE can perform DC tests by opening the first relay barrier 133 and closing the second relay barrier 134.

The solution of the present disclosure therefore solves the technical problem and achieves various advantages including: a particularly low cost, a great structural and functional reliability and an improved speed of the testing process.

In order to better understand the scope of the present invention, the term "comprising" and derivatives thereof, as used herein, are intended to be open terms that specify the presence of the specified features, elements, components, groups, integers and/or steps, but do not exclude the presence of other features, elements, components, groups, integers and/or steps which are not specified. The foregoing also applies to words having similar meanings such as the terms, "including", "having" and derivatives thereof.

Although only embodiments selected to illustrate the present invention have been chosen, it will be clear to those skilled in the art from this disclosure that various changes and modifications can be made herein without departing from the scope of the invention as defined in the appended claims.

## Claims

1. Automated test equipment (100) comprising:
a housing (130) for a device under test (200);
a first hardware portion (110) arranged to perform dynamic tests, in particular alternating current dynamic tests, on the device under test (200);
a second hardware portion (120) arranged to perform direct current tests on the device under test (200);
a first relay barrier (133) interposed between the hardware of the first portion (110) and the device under test (200);
a second relay barrier (134) interposed between the hardware of the second portion (120) and the device under test (200);
wherein the first relay barrier (133) and the second relay barrier (134) can be alternatively switched to allow performing dynamic tests via the first hardware portion (110) or direct current tests via the second hardware portion (120).

2. Automated test equipment (100) according to claim 1, wherein the housing (130) is couplable to the second hardware portion (120) via a DC connector (132), said DC connector (132) being configured to connect to the second portion (120) with a transmission cable (124).

3. Automated test equipment (100) according to claim 2, wherein the housing (130) is couplable to the first hardware portion (110) via an AC connector (131), said AC connector (131) being configured to allow hard docking of the housing (130) with the first hardware portion (110).

4. Automated test equipment (100) according to claim 3, wherein said DC connector (132) and said AC connector (131) are positioned opposite each other on the housing (130).

5. Automated test equipment (100) according to one of the preceding claims, wherein said first hardware portion (110) comprises a first measurement and control module (111).

6. Automated test equipment (100) according to one of the preceding claims, wherein said first hardware portion (110) comprises a first digital interface module (112).

7. Automated test equipment (100) according to one of the preceding claims, wherein said second hardware portion (120) comprises a second measurement and control module (121).

8. Automated test equipment (100) according to one of the preceding claims, wherein said second hardware portion (120) comprises a second digital interface module (123).

9. Automated test equipment (100) according to one of the preceding claims, wherein said first relay barrier (133) and/or said second relay barrier (134) comprise at least one first terminal (2) and at least one second terminal (3), at least one actuation unit (4) comprising an electrovalve (40) and an actuator (41) which is integral with a contact plate (43) capable of moving from a first position, in which this is in contact with both said at least one first terminal (2) and said at least one second terminal (3) by putting them in electrical contact, to a second stop position, in which it is distant from said at least one first terminal (2) and at least one second terminal (3), wherein said electrovalve (40) is arranged to control said actuator (41) by moving said contact plate (43) between said first stop position and said second stop position.

10. Automated test equipment (100) according to claim 9, wherein said first relay barrier (133) and/or said second relay barrier (134) comprise a plurality of first terminals (2), a plurality of second terminals (3) and a plurality of contact plates (43) configured to short-circuit said first (2) and said second (3) terminals two by two, wherein a single relay barrier (133) comprises a single actuation unit (4) arranged to synchronously move said plurality of contact plates (43).

11. Automated test equipment (100) according to one of claims 9 or 10, wherein said at least one first terminal (2) and said at least one second terminal (3) comprise electrical contacts (20, 30) which are retractable within a respective housing (21, 31) in opposition to the abutment of an elastic element, said actuator (4) comprising a piston (45) which is movable in a cylinder and is connected by a stem (42) to a front plate (44) which carries said contact plate (43), said actuator (4) comprising a spring (46) acting on said movable piston (45) in opposition to the movement of said movable piston (45) controlled by said electrovalve (40).

12. Automated test equipment (100) according to one of claims 9-11, wherein said first terminal (2), said second terminal (3) and said contact plate define a main circuit (7), the first and/or second relay barriers (133, 134) further comprising at least one diagnostic circuit (5) adapted to detect the correct opening and closing conditions of the main circuit (7).

13. Automated test equipment (100) according to claim 12, wherein said diagnostic circuit (5) comprises a first pair of interface contacts (50) which are accessible from the outside of a casing (6), the diagnostic circuit (5) being configured to short-circuit the first pair of interface contacts (50) only when the main circuit is in open configuration with the front plate (44) in the corresponding first stop position.

14. Automated test equipment (100) according to claim 13, wherein the contacts of the first pair of interface contacts (50) are connected two by two with the contacts of a second pair of interface contacts (51), said second pair of interface contacts (51) internally facing onto the chamber in which the front plate (44) runs, said front plate (44) comprising at least one conductive portion (54) which comes into contact with the second pair of interface contacts (51), short-circuiting it, when said front plate (44) reaches the first stop position.

15. Automated test equipment (100) according to one of claims 12-14, wherein said diagnostic circuit (5) comprises a third pair of interface contacts (52) which are accessible from the outside of a casing (6), the diagnostic circuit (5) being configured to short-circuit the third pair of interface contacts (52) only when the main circuit is in closed configuration with the front plate (44) in the corresponding second stop position.
